(19) Europäisches Patentamt

European Patent Office

Office européen des brevets

(11) Veröffentlichungsnummer: **0 421 094 A2**

# (12) EUROPÄISCHE PATENTANMELDUNG

(21) Anmeldenummer: **90115490.6**

(22) Anmeldetag: **13.08.90**

(51) Int. Cl.⁵: **H05K 7/14**

(30) Priorität: **06.10.89 DE 3933369**

(43) Veröffentlichungstag der Anmeldung:
**10.04.91 Patentblatt 91/15**

(84) Benannte Vertragsstaaten:
**AT BE CH DE ES FR GB IT LI NL SE**

(71) Anmelder: **SENSYCON GESELLSCHAFT FÜR INDUSTRIELLE SENSORSYSTEME UND PROZESSLEITTECHNIK MBH**
**Hackethalstrasse 7**
**W-3000 Hannover 1(DE)**

(72) Erfinder: **Byell, Horst**
**Achatweg 6**
**W-3008 Garbsen 1(DE)**
Erfinder: **Saager, Dieter**
**Karlstrasse 5a**
**W-3013 Barsinghausen(DE)**

(74) Vertreter: **Klein, Thomas, Dipl.-Ing. (FH) et al**
**Sodener Strasse 9 Postfach 6140**
**W-6231 Schwalbach a. Ts.(DE)**

(54) **Elektronisches Gerät.**

(57) Die Erfindung bezieht sich auf ein elektronisches Gerät mit einem etwa kastenförmigen Gehäuse 1, das mit einer Bedieneinheit 17 und einer Kontaktierungseinheit 15 und 16 versehen ist. In dem Gehäuse 1 ist eine Verbindungsleiterplatte 8 angeordnet, an der Steckkontakteinrichtungen 9 befestigt sind, mit denen jeweils Steckgegenkontakteinrichtungen zumindest einer weiteren Leiterplatte 10 in Eingriff bringbar sind. Auf der Verbindungsleiterplatte 8 sind Leiter zur Verbindung der Steckkontakteinrichtungen 9 untereinander und mit der Bedieneinheit 17 und der Kontaktierungseinheit 15 und 16 vorhanden. In dem Gehäuse 1 ist eine sich etwa in Richtung von der Gehäuserückseite zu der Gehäusefrontseite erstreckende Führung befestigt, auf der die Verbindungsleiterplatte 8 verschiebbar geführt und auf der frontseitigen Öffnung 2 des Gehäuses 1 zumindest weitgehend herausbewegbar angeordnet ist.

Figur 1

## ELEKTRONISCHES GERÄT

Die Erfindung bezieht sich auf ein elektronisches Gerät mit einem etwa kastenförmigen Gehäuse, das mit einer Bedieneinheit und einer Kontaktierungseinheit versehen ist, mit einer im Gehäuse angeordneten Verbindungsleiterplatte an der Steckkontakteinrichtungen befestigt sind, mit denen jeweils Steckkontakteinrichtungen zumindest einer weiteren Leiterplatte in Eingriff bringbar sind, wobei auf der Verbindungsleiterplatte Leiter zur Verbindung der Steckkontakteinrichtungen untereinander und mit der Bedieneinheit und der Kontaktierungseinheit vorhanden sind.

Bei derartigen elektronischen Geräten besteht das Problem, daß dessen Baueinheiten nur unter großem Aufwand bzw. nur schwer zugänglich sind, so daß ein Austausch oder eine Ergänzung von Baueinheiten nur schwer möglich ist.

Aufgabe der Erfindung ist es, ein elektronisches Gerät der eingangs genannten Art zu schaffen, bei dem die Baueinheiten wie z.B. Leiterplatten ohne großen Aufwand aus dem Gehäuse entnehmbar und wieder einsetzbar sind.

Diese Aufgabe wird erfindungsgemäß dadurch gelöst, daß in dem Gehäuse eine sich etwa in Richtung von der Gehäuserückseite zur Gehäusefrontseite erstreckende Führung befestigt ist, auf der die Verbindungsleiterplatte verschiebbar geführt und aus der frontseitigen Öffnung des Gehäuses zumindest weitgehend herausbewegbar angeordnet ist. Durch diesen Aufbau kann zum Zwecke einer Entnahme oder Ergänzung einer auf der Verbindungsleiterplatte anordenbaren Einheit, wie z.B. einer Leiterplatte die Verbindungsleiterplatte aus dem Gehäuse herausbewegt werden, so daß die darauf angeordneten Einheiten leicht und frei zugänglich sind.

Vorzugsweise ist die Führung eine Schubführung, auf der ein mit der Verbindungsleiterplatte verbundenes Führungsgegenstück verschiebbar angeordnet ist, wobei eine besondere Leichtgängigkeit bei guten Führungseigenschaften erreicht wird, wenn die Führung eine Wälzschubführung ist.

Ist die Führung auch eine Teleskopführung, so kann die Verbindungsleiterplatte vollständig aus dem Gehäuse herausbewegt werden.

Zur mechanischen Entlastung der Verbindungsleiterplatte kann diese auf einem Schubträger befestigt sein, der verschiebbar auf der Führung angeordnet ist, wobei der Schubträger vorzugsweise eine sich etwa parallel zum Boden des Gehäuses erstreckende Trägertafel ist.

Eine exakte und stabile Anordnung wird dadurch erreicht, daß jeweils eine Führung an jeder Seitenwand des Gehäuses angeordnet ist.

Ist die Verbindungsleiterplatte etwa parallel zur Trägertafel aus der Trägertafel und die weitere Leiterplatte senkrecht nach oben ragend auf der Verbindungsleiterplatte stehend angeordnet, so sind die weiteren Leiterplatten bei aus dem Gehäuse herausgezogener Trägertafel direkt und frei von oben einsetzbar bzw. entnehmbar.

Zur stabilen Halterung der Leiterplatten kann der Schubträger einen Leiterplattenhalter aufweisen, in dem die Leiterplatten in Einschubführungen geführt anordenbar sind.

Ist auf der Verbindungsleiterplatte eine mit den Leiterbahnen verbindbare Energieversorgungseinheit angeordnet oder sind auf der Verbindungsleiterplatte mit den Leiterbahnen verbundene elektronische Bauteile insbesondere Mikroprozessoren angeordnet, so sind auch diese Einheiten direkt frei von oben zugänglich.

Zum Schutz der im Gehäuse angordneten Einheiten kann die frontseitige Öffnung des Gehäuses durch eine Frontplatte verschließbar sein.

Sind Frontplatte und Schubträger miteinander verbunden, so wird mit einem Handgriff ein Öffnen des Gehäuses und ein Zugänglichmachen der im Gehäuse angeordneten Einheiten erreicht.

Sind weiterhin die Kontaktierungseinheit und/oder die Bedieneinheit derart an der Frontplatte angeordnet, daß sie von der Gehäuseaußenseite kontaktierbar und/oder bedienbar sind, so sind alle elektrischen und elektronischen miteinander wirkenden Einheiten zu einer Baueinheit zusammengefaßt, so daß keine Verbindungsprobleme durch die Ein- und Ausschubbewegung des Schubträgers vorhanden sind.

Zur Kühlung der auf den Leiterplatten und der Verbindungsleiterplatte angeordneten Wärme erzeugenden elektrischen und elektronischen Bauteile kann am Schubträger eine Lüftereinheit angeordnet sein, durch die die Außenluft ansaugbar und im Bereich der Leiterplatte in das Gehäuse einblasbar ist. Dazu kann im Bereich der Lüftereinheit im Boden des Gehäuses ein Lufteinlaß und im Deckel des Gehäuses ein Luftauslaß angeornet sein, wobei die Leiterplatten in einem Bereich zwischen Lufteinlaß und Luftauslaß angeordnet sind, wozu auf einfache Weise der Boden und/oder der Deckel im Bereich des Lufteinlasses und/oder des Luftauslasses als Lochblech ausgebildet sind.

Ist auf der Einlaßseite der Lüftereinheit eine Filtereinheit angeordnet, so wird nur gereinigte Luft in das Gehäuse geblasen. Der sich dabei ergebende geringe Überdruck im Gehäuse gegenüber dem Außendruck verhindert, daß durch Spalten und Öffnungen im Gehäuse ungereinigte Luft in das Gehäuse eindrigen und zu Defekten bei den elektronischen Bauteilen führen kann.

Ein einfacher Aufbau ergibt sich, wenn die Filtereinheit eine stärke Trägerplatte besitzt, die im den Lufteinlaß der Lüftereinheit etwa abdeckenden Bereich eine mit einer Filterschicht abgedeckte Ausnehmung aufweist.

Ist die Lüftereinheit an ihrer Einlaßseite mit Führungen. versehen, in die die Filtereinheit einführbar ist, so kann die Filtereinheit z.B. zum Wechsel ohne großen Aufwand ausgetauscht werden.

Diese leichte Austauschbarkeit wird noch weiter verbessert, wenn die Frontplatte im Bereich der Filtereinheit eine durch eine Abdeckung verschließbare Öffnung aufweist, durch die die Filtereinheit ein- bzw. ausbaubar ist.

Ein Ausführungsbeispiel der Erfindung wird in der Zeichnung dargestellt und ist im folgenden näher beschrieben. Es zeigen

Figur 1 eine Ansicht eines elektronischen Geräts teilweise im Schnitt,

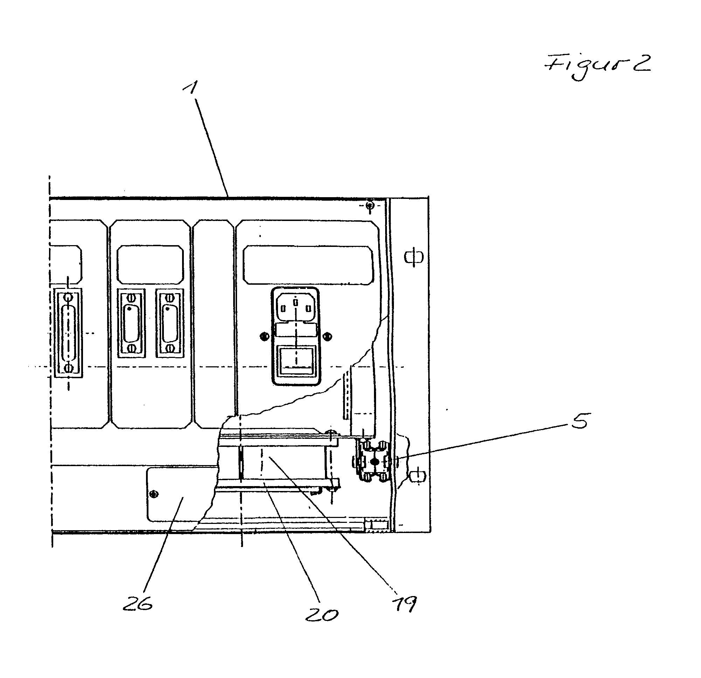

Figur 2 eine Teilansicht des Geräts nach Figur 1 teilweise im Schnitt,

Figur 3 eine Seitenansicht des Geräts nach Figur 1 mit entfernter Seitenwand,

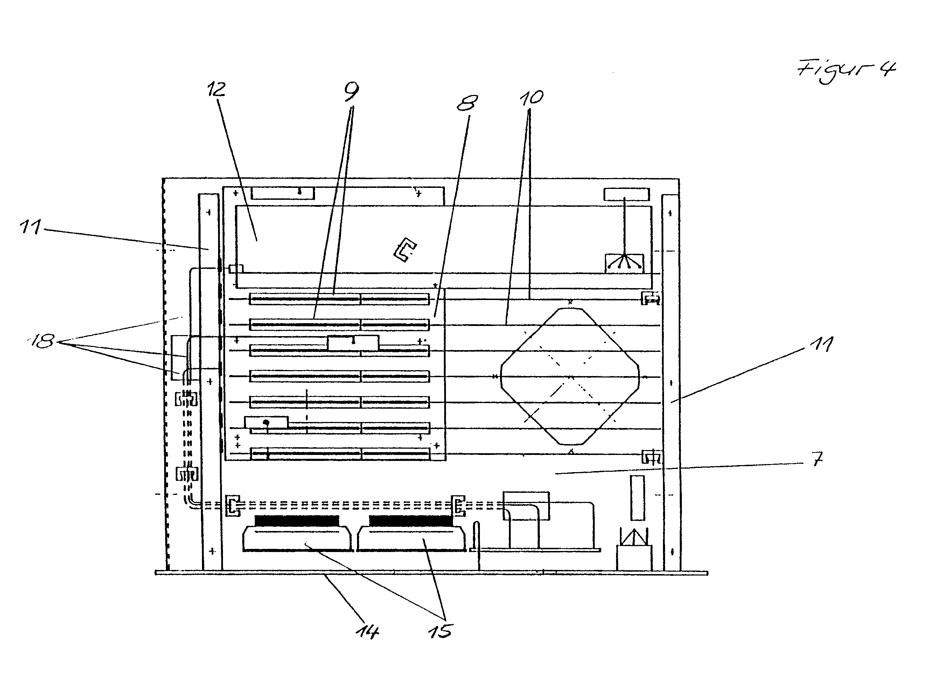

Figur 4 eine Draufsicht auf die in das Gehäuse einschiebbare Einschubeinheit des Geräts nach Figur 1,

Figur 5 eine Draufsicht einer Filtereinheit des Gerätsk nach Figur 1,

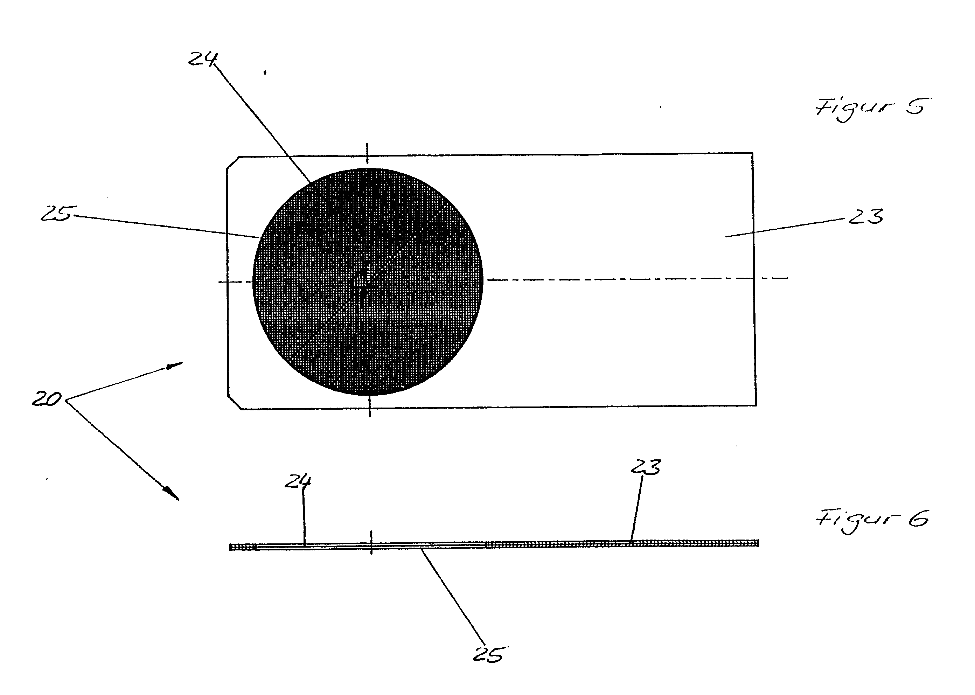

Figur 6 eine Seitenansicht im Schnitt der Filtereinheit nach Figur 5.

Das in den Figuren dargestellte Gerät besitzt ein kastenförmiges Gehäuse 1, mit einer frontseitigen Öffnung 2. In einem Abstand zum Boden 3 des Gehäuses 1 sind an beiden Seitenwänden 4 horizontal sich erstreckend Wälzschubführungen 5 befestigt, auf denen Führungsgegenstände 6 verschiebbar angeordnet sind, die an der Unterseite entlang der seitlichen Ränder einer Trägertafel 7 angeordnet sind.

Mit einem Abstand ist etwa parallel zur Trägertafel 7 auf dieser eine Verbindungsleiterplatte 8 befestigt, die mit Steckkontakteinrichtungen 9 versehen ist, auf die senkrecht nach oben stehend Leiterplatten 10 mit ihren Steckgegenkontakten aufgesteckt sind.

Die Ebene der Leiterplatten 10 ist etwa parallel zur frontseitigen Ebene des Gehäuses 1 ausgerichtet.

Die Verbindungsleiterplatte 8 erstreckt sich etwa über die halbe Breite des Gehäuses 1, während die Leiterplatten 10 sich fest über die ganze Breite des Gehäuses 1 erstrecken.

Auf der Trägertafel 7 ist weiterhin ein Leiterplattenhalter 11 befestigt ist, der mit Einschubführungen versehen ist, in denen die Leiterplatten geführt angeordnet und gehalten sind.

Im hinteren Bereich ist auf der Verbindungsleiterplatte 8 eine Energieversorgungseinheit 12 befestigt.

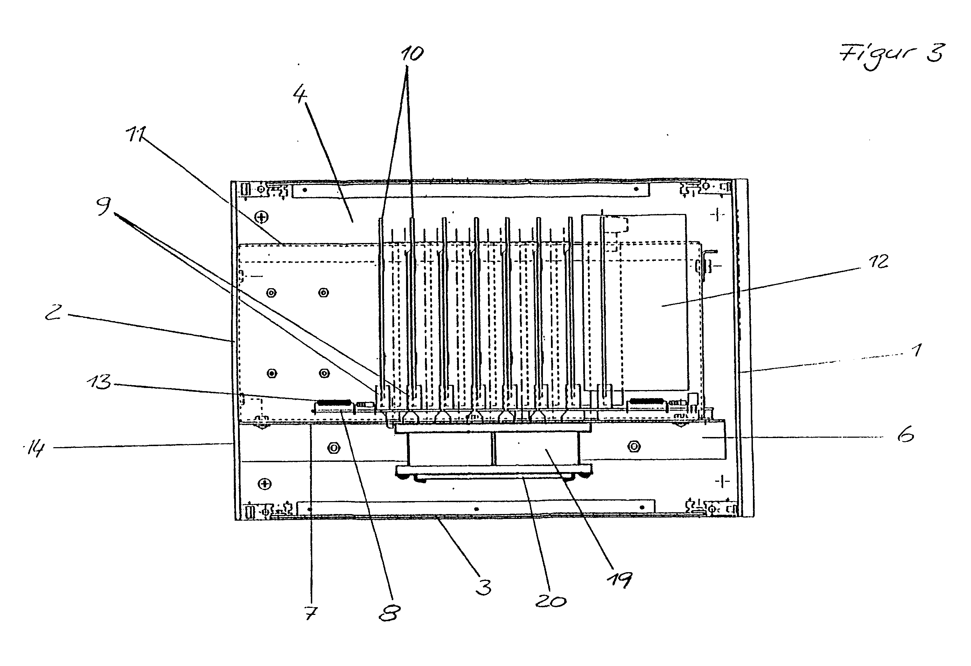

Wie in Figur 3 zu erkennen ist, sind auf der Verbindungsleiterplatte 8 weiterhin elektronische Bauteile 13 angeordnet.

Eine Frontplatte 14, durch die die Öffnung 2 des Gehäuses 1 verschließbar ist, ist an der frontseitigen Kante rechtwinklig zur Ebene der Trägertafel 7 an der Trägertafel 7 befestigt und bildet mit der Trägertafel 7 und den darauf angeordneten Einheiten eine Schubeinheit, die im eingeschobenen Zustand sich innerhalb des Gehäuses 1 befindet. Dabei verschließt die Frontplatte 14 die Öffnung 2. Im ausgefahrenen Zustand befindet sich die Schubeinheit weitgehend außerhalb des Gehäuses 1, so daß alle auf der Verbindungsleiterplatte 8 angeordneten Einheiten direkt von oben zugänglich sind.

An der Frontplate 14 sind als Steckkontakte ausgebildete Kontaktierungseinheiten 15 zum Anschluß von z.B. externen Datenleitungen sowie eine Kontaktierungseinheit 16 zur Energieversorgung angeordnet. Weiterhin ist an der Frontplatte 14 auch eine als Wippschalter ausgebildete Bedieneinheit 17 vorhanden.

Alle Bedienungs- und Kontaktierungseinheiten 15, 16 und 17 sind von der Gehäuseaußenseite kontaktierbar bzw. bedienbar.

Durch nicht dargestellte auf der Verbindungsleiterplatte 8 angeordnete Leiterbahnen sind die Energieversorgungseinheit 12 mit den Steckkontakteinrichtungen sowie diese untereinander und mi den elektrischen Bauteilen 13 verbunden.

Die Kontaktierungseinheit 16 ist mit der Energieversorgungseinheit 12 und die Bedieneinheit 17 mit den Leiterbahnen über auf Verbindungsleiterplatte 8 angeordnete Leitungen 18 verbunden.

Da die kompletten elektrischen und elektronischen Einheiten auf der Schubeinheit angeordnet sind, kann diese auf dem Gehäuse 1 herausgefahren und Leiterplatten 10 ausgetauscht oder ergänzt werden, ohne daß die Datenleitungen und die Energieversorgung abgetrennt werden muß. Eine Betriebsunterbrechung wird dadurch vermeiden.

Im rechten Bereich der Trägertafel 7 ist auf deren Unterseite eine Lüftereinheit 19 angeordnet, durch die die Kühlluft zwischen die Leiterplatten 10 geblasen wird.

Die Lüftereinheit 10 trägt auf ihrer Unterseite eine Filtereinheit 20, über die von der Lüftereinheit 19 Luft angesaugt wird, die über die Öffnungen des in diesem Bereich als Lochblech ausgebildeten Bodens 3 von außen eintritt.

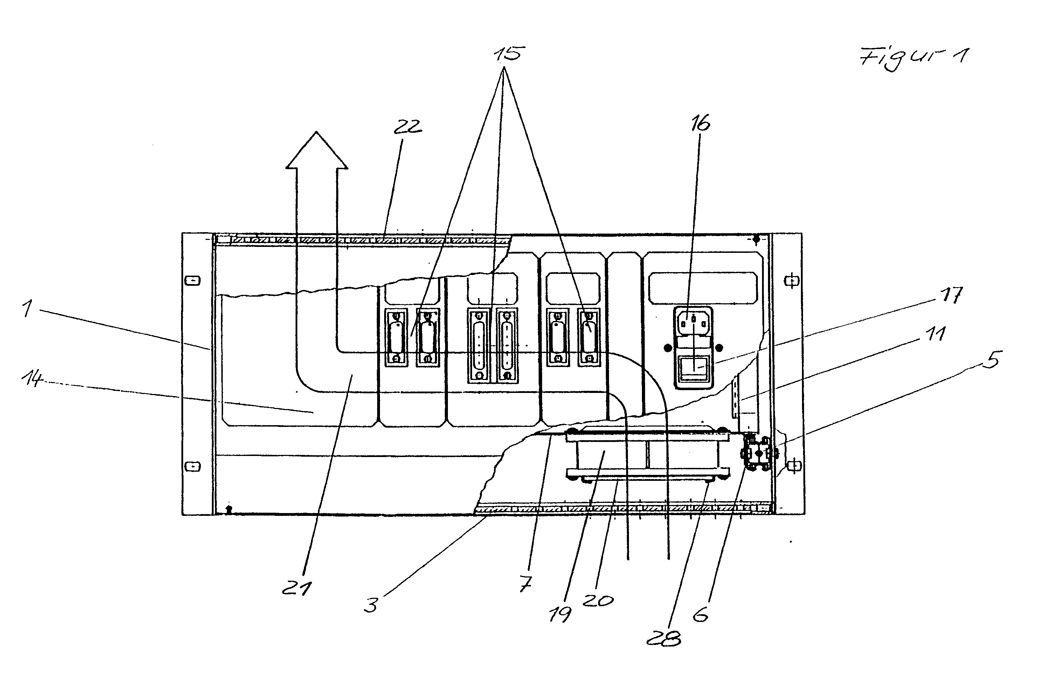

Wie schematisch in Figur 1 dargestellt ist, streicht der Luftstrom 21 an den Leiterplatten 10 entlang und tritt an den Öffnungen des im linken Bereichs als Lochblech ausgebildeten Deckels 22 des Gehäuses 1 wieder aus.

Die Filtereinheit 20 besteht aus einer Trägerplatte 23, die zwei sandwichartig aufeinanderliegende Platten aufweist, zwischen denen eine Filtermatte angeordnet ist.

In dem unter der Lüftereinheit 19 befindlichen Bereich weisen die Platten eine Aussparung 25 auf, so daß dort nur die Filtermatte 24 vorhanden ist, durch die die angesaugte Luft hindurchtreten kann.

Zum Wechsel der Filtereinheit 20 braucht nur eine im Bereich der Filtereinheit 20 in der Frontplatte 14 ausgebildete und durch eine Abdeckung 26 verschließbare Öffnung 27 geöffnet und die in Führungen 28 an der Unterseite der Lüftereinheit 19 angeordnete Filtereinheit 20 entnommen bzw. ausgetauscht werden.

**Ansprüche**

1. Elektronisches Gerät mit einem etwa kastenförmigen Gehäuse, das mit einer Bedieneinheit und einer Kontaktierungseinheit versehen ist, mit einer im Gehäuse angeordneten Verbindungsleiterplatte an der Steckkontakteinrichtungen befestigt sind, mit denen jeweils Steckgegenkontakteinrichtungen zumindest einer weiteren Leiterplatte in Eingriff bringbar sind, wobei auf der Verbindungsleiterplatte Leiter zur Verbindung der Steckkontakteinrichtungen untereinander und mit der Bedieneinheit und der Kontaktierungseinheit vorhanden sind, dadurch gekennzeichnet, daß in dem Gehäuse (1) eine sich etwa in Richtung von der Gehäuserückseite zur Gehäusefrontseite erstreckende Führung befestigt ist, auf der die Verbindungsleiterplatte (8) verschiebbar geführt und aus der frontseitigen Öffnung (2) des Gehäuses (1) zumindest weitgehend herausbewegbar angeordnet ist.

2. Gerät nach Anspruch 1, dadurch gekennzeichnet, daß die Führung eine Schubführung ist, auf der ein mit der Verbindungsleiterplatte (8) verbundenes Führungsgegenstück (6) verschiebbar angeordnet ist.

3. Gerät nach Anspruch 2, dadurch gekennzeichnet, daß die Führung eine Wälzschubführung (5) ist.

4. Gerät nach einem der vorhergehenden Ansprüche, dadurch gekennzeichnet, daß die Führung eine Teleskopführung ist.

5. Gerät nach einem der vorhergehenden Ansprüche, dadurch gekennzeichnet, daß die Verbindungsleiterplatte (8) auf einem Schubträger befestigt ist, der verschiebbar auf der Führung angeordnet ist.

6. Gerät nach Anspruch 5, dadurch gekennzeichnet, daß der Schubträger eine sich etwa parallel zum Boden des Gehäuses (1) erstreckende Trägertafel ist.

7. Gerät nach einem der vorhergehenden Ansprüche, dadurch gekennzeichnet, daß jeweils eine Führung an jeder Seitenwand des Gehäuses angeordnet ist.

8. Gerät nach einem der vorhergehenden Ansprüche, dadurch gekennzeichnet, daß die Verbindungsleiterplatte (8) etwa parallel zur Trägertafel (7) auf der Trägertafel (7) und die weitere Leiterplatte (10) senkrecht nach oben ragend auf der Verbindungsleiterplatte (8) stehend angeordnet ist.

9. Gerät nach einem der vorhergehenden Ansprüche, dadurch gekennzeichnet, daß der Schubträger einen Leiterplattenhalter (11) aufweist, in dem die Lei terplatte (10) in Einschubführungen geführt anordenbar ist.

10. Gerät nach einem der vorhergehenden Ansprüche, dadurch gekennzeichnet, daß auf der Verbindungsleiterplatte (8) eine mit den Leiterbahnen verbindbare Energieversorgungseinheit (12) anordenbar ist.

11. Gerät nach einem der vorhergehenden Ansprüche, dadurch gekennzeichnet, daß auf der Verbindungsleiterplatte (8) mit den Leiterbahnen verbundene elektronische Bauteile (13) insbesondere Mikroprozessoren angeordnet sind.

12. Gerät nach einem der vorhergehenden Ansprüche, dadurch gekennzeichnet, daß die frontseitige Öffnung (2) des Gehäuses (1) durch eine Frontplatte (14) verschließbar ist.

13. Gerät nach Anspruch 12, dadurch gekennzeichnet, daß Frontplatte (14) und Schubträger fest miteinander verbunden sind.

14. Gerät nach Anspruch 12, dadurch gekennzeichnet, daß die Kontaktierungseinheit (15, 16) und/oder die Bedieneinheit (17) derart an der Frontplatte (14) angeordnet sind, daß sie von der Gehäuseaußenseite kontaktierbar und/oder bedienbar sind.

15. Gerät nach einem der vorhergehenden Ansprüche, dadurch gekennzeichnet, daß am Schubträger eine Lüftereinheit (19) angeordnet ist, durch die Außenluft ansaugbar und im Bereich der Leiterplatten (10) in das Gehäuse (1) einblasbar ist.

16. Gerät nach Anspruch 15, dadurch gekennzeichnet, daß im Bereich der Lüftereinheit (19) im Boden (3) des Gehäuses (1) ein Lufteinlaß und im Deckel (22) des Gehäuses (1) ein Luftauslaß angeordnet sind, wobei die Leiterplatten (10) in einem Bereich zwischen Lufteinlaß und Luftauslaß angeordnet sind.

17. Gerät nach Anspruch 16, dadurch gekennzeichnet, daß der Boden (3) und/oder der Deckel (22) im Bereich des Lufteinlasses und/Oder des Luftauslasses als Lochblech ausgebildet sind.

18. Gerät nach Anspruch 16, dadurch gekennzeichnet, daß auf der Einlaßseite der Lüftereinheit (19) eine Filtereinheit (20) angeordnet ist.

19. Gerät nach Anspruch 18, dadurch gekennzeichnet, daß die Filtereinheit (20) eine starre Trägerplatte (23) besitzt, die im den Lufteinlaß der Lüftereinheit (19) etwa abdeckenden Bereich eine mit einer Filterschicht abgedeckte Aussparung (25) aufweist.

20. Gerät nach Anspruch 18, dadurch gekennzeichnet, daß die Lüftereinheit (19) an ihrer Einlaßseite mit Führungen (28) versehen ist, in die die Filtereinheit (20) einführbar ist.

21. Gerät nach Anspruch 18, dadurch gekennzeichnet, daß die Frontplatte (14) im Bereich der Filtereinheit (20) eine durch eine Abdeckung (26) verschließbare Öffnung (20) aufweist, durch die die Filtereinheit (20 ein- bzw. ausbaubar ist.

Figur 1

EP 0 421 094 A2

Figur 2

EP 0 421 094 A2

Figur 3

EP 0 421 094 A2

Figur 4

EP 0 421 094 A2

Figur 5

Figur 6